Europäisches Patentamt

European Patent Office

Office européen des brevets

(19)

(11) Veröffentlichungsnummer : **0 030 004**
**B1**

(12) # EUROPÄISCHE PATENTSCHRIFT

(45) Veröffentlichungstag der Patentschrift :
**01.06.83**

(21) Anmeldenummer : **80107393.3**

(22) Anmeldetag : **26.11.80**

(51) Int. Cl.³ : **H 04 B 3/44, G 01 R 31/00**

(54) Schaltungsanordnung zur Fernspeisung von Zwischenstellen einer Einrichtung der Nachrichtenübertragungstechnik mittels Gleichstrom-Reihenspeisung.

(30) Priorität : **30.11.79 DE 2948335**

(43) Veröffentlichungstag der Anmeldung :
**10.06.81 Patentblatt 81/23**

(45) Bekanntmachung des Hinweises auf die Patenterteilung : **01.06.83 Patentblatt 83/22**

(84) Benannte Vertragsstaaten :
**AT BE CH DE FR GB IT LI NL SE**

(56) Entgegenhaltungen :
**EP A 0 007 628**
**DE A 2 260 335**

(73) Patentinhaber : **SIEMENS AKTIENGESELLSCHAFT**
**Berlin und München Wittelsbacherplatz 2**
**D-8000 München 2 (DE)**

(72) Erfinder : **Kraicar, Heinz, Dipl.-Ing.**
**Lindenberg 60 a**
**D-8134 Pöcking (DE)**
Erfinder : **Ziegler, Alfred, Dipl.-Ing.**
**Laimer Platz 1**
**D-8000 München 21 (DE)**

Schaltungsanordnung zur Fernspeisung von Zwischenstellen einer Einrichtung der Nachrichtenübertragungstechnik mittels Gleichstrom-Reihenspeisung

Die Erfindung bezieht sich auf eine Schaltungsanordnung zur Fernspeisung von Zwischenstellen einer Einrichtung der Nachrichtenübertragungstechnik mittels Gleichstrom-Reihenspeisung, wobei in einem Fernspeisekreis eine Reihenschaltung von zwei in Speisestellen der Nachrichtenübertragungseinrichtung vorgesehenen, über ein Speiseadernpaar miteinander verbundenen Stromquellen vorgesehen ist und wobei eine in einer ersten Speisestelle enthaltene erste Stromquelle einen konstanten Nennstrom und eine in einer zweiten Speisestelle enthaltene zweite Stromquelle einen gegenüber dem Nennstrom reduzierten Konstantstrom abgeben kann, derart, daß im Normalbetrieb nur die den Nennstrom abgebende erste Speisestelle speist.

Eine derartige Schaltungsanordnung wurde bereits vorgeschlagen (EP-A-79 102 651.1).

Ferner ist eine Schaltungsanordnung zur Fernspeisung von Zwischenstellen mittels Gleichstrom-Reihenspeisung, bei der in einem Fernspeisekreis eine Reihenschaltung von zwei über ein Speiseadernpaar miteinander verbundenen Konstantstromquellen vorgesehen ist und bei der jede der beiden Konstantstromquellen derart bemessen ist, daß sie die ganze Übertragungsstrecke versorgen kann, z. B. aus « The Post Office Electrical Engineers' Journal », Vol. 66, Part. 3, Okt. 1973, Seiten 135 bis 137, bekannt.

Bei der bekannten Schaltungsanordnung sind zum Zwecke des Berührungsschutzes an beiden Enden eines Fernspeisekreises Konstantstromquellen angeschlossen. Stimmen die beiden Konstantströme exakt überein und werden die beiden Adern des Speisekreises an irgendeiner beliebigen Stelle versehentlich über den Körperwiderstand einer Person miteinander verbunden, so führt eine solche fehlerhafte Verbindung dazu, daß an der Fehlerstelle die Spannung zusammenbricht und daß sich für die beiden Speisestellen eine entsprechende Lastaufteilung einstellt. Die Anordnung hat den Zweck sicherzustellen, daß Personen, die die Speiseadern zufällig berühren, hierdurch nicht zu Schaden kommen können. Diese Funktion hat zur Voraussetzung, daß die von den Konstantstromquellen gelieferten Ströme möglichst gut übereinstimmen, da im Berührungsfalle der Differenzstrom über die fehlerhafte Querverbindung fließt.

Bei einer derartigen Speisung kann die Spannungsverteilung entlang der Strecke beliebig sein.

Um einen Schleifenschluß zwischen den Speiseadern erkennen zu können, kann man entsprechend dem genannten älteren Vorschlag (EP-A-791 026 51.1) eine der beiden Speisestellen mit verringertem Fernspeisestrom-Sollwert arbeiten lassen. Damit verlagert sich bei Normalbetrieb der Potential-Nullpunkt eindeutig in diese Speisestelle, die dann im Fehlerfall aktiv zu speisen beginnt.

Die genannten Potentialverhältnisse gestatten es, durch eine Überwachung der Spannung am Ausgang der auf verringerten Fernspeisestrom eingestellten Speisestelle Streckenfehler festzustellen. Beginnt die Speisestelle im Fehlerfall aktiv zu speisen, so fließt allerdings ein gegenüber dem Nennstrom kleinerer Strom. Dieser verringerte Fernspeisestrom ist für den Betrieb der Zwischenverstärker oder Zwischenregeneratoren dann ohne Bedeutung, wenn diese über eine spannungsstabilisierende Schaltung, z. B. Z-Dioden oder regelnde Umrichter betrieben werden.

Aufgabe der Erfindung ist es, die Schaltungsanordnung derart auszubilden, daß sie unter Beibehaltung der genannten Fehlerüberwachungsmöglichkeit auch für Übertragungsstrecken angewendet werden kann, die unmittelbar gespeiste Zwischenverstärker bzw. Zwischenregeneratoren enthalten, die eine wesentliche Stromsenkung nicht ohne weiteres zulassen.

Überlegungen im Rahmen der Erfindung haben ergeben, daß man den gewünschten eindeutigen Potentialverlauf auf der Strecke auch dadurch erreichen kann, daß wenigstens eine der beiden Stromquellen eine bestimmte, von der Ausgangsspannung abhängige Regelcharakteristik besitzt.

Gemäß der Erfindung wird die Schaltungsanordnung zur Lösung dieser Aufgabe derart ausgebildet, daß wenigstens die zweite Stromquelle eine derart von der Ausgangsspannung abhängige Regelcharakteristik hat, daß in einem vorgegebenen Bereich der Ausgangsspannung der Nennstrom und unterhalb dieses Spannungsbereiches der reduzierte Konstantstrom abgegeben werden. Unter dem vorgegebenen Bereich der Ausgangsspannung ist dabei insbesondere ein Arbeitsbereich zu verstehen, dessen unterer Grenzwert die Ausgangsspannung bei Speisung eines Verstärkerfeldes mit reduziertem Nennstrom und dessen oberer Grenzwert die Ausgangsspannung bei Speisung der gesamten Strecke mit Nennstrom ist. Haben beide Stromquellen die genannte Regelcharakteristik, so übernimmt die zuerst eingeschaltete Speisestelle die Versorgung der gesamten Strecke. Um das andere Speisegerät in den speisenden Zustand zu versetzen, genügt es, bei dem speisenden Speisegerät den Ausgang vorübergehend kurzzuschließen oder den Ausgangsstrom vorübergehend zu reduzieren.

Durch diese Maßnahmen ergibt sich der Vorteil, daß bei einem Streckenfehler die Fernspeisung mit Nennstrom aufrecht erhalten bleibt und dabei aufgrund eindeutiger Potentialverhältnisse auf der Strecke der Streckenfehler dadurch sicher ermittelt bzw. gemeldet werden kann.

In weiterer Ausgestaltung der Erfindung wird die Schaltungsanordnung derart ausgebildet, daß der untere Grenzwert des vorgegebenen Bereiches der Ausgangsspannung derart bemessen ist, daß er etwas kleiner ist als die zur Speisung eines Verstärkerfeldes mit dem reduzierten Konstantstrom erforderliche Ausgangsspannung. Durch diese Maßnahmen ergibt sich der Vorteil, daß die Zwischenstellen auch bei einem Schleifenschluß an beliebiger Stelle der Strecke mit Nennstrom gespeist werden.

In Weiterbildung der Erfindung läßt sich die genannte Regelcharakteristik dadurch auf besonders vorteilhafte Weise erzielen, daß wenigstens die zweite Speisestelle einen an deren Ausgangsspannung angeschlossenen Schwellwertschalter enthält, der bei Ausgangsspannungen oberhalb des unteren Grenzwertes des vorgegebenen Bereiches der Ausgangsspannung einen der Stromquelle zugeordneten Konstantstromregler auf den Nennstrom einstellt und daß der Schwellwertschalter auf Änderungen der Ausgangsspannung mit einer vorgegebenen ersten Verzögerung anspricht. Die erste Verzögerung hat dabei den Vorteil, daß kurze Spannungsimpulse, die insbesondere von Beeinflussungen auf der Strecke herrühren, die Schaltungseinrichtung nicht ohne weiteres in einem Zustand überführen können, bei dem beide Speisestellen zugleich Nennstrom in eine an sich intakte Strecke einspeisen.

Es kann sich ferner als zweckmäßig erweisen, die Schaltungsanordnung derart auszubilden, daß wenigstens die zweite Speisestelle unabhängig von ihrer Ausgangsspannung vorübergehend auf einen reduzierten Konstantstrom einstellbar ist. Auf diese Weise läßt sich erreichen, daß sich die betreffende Speisestelle durch unmittelbar manuelle oder selbsttätige Steuerung vom speisenden in den nicht speisenden Zustand überführen läßt.

Andererseits kann man die Schaltungsanordnung zweckmäßigerweise derart ausbilden, daß wenigstens die erste Speisestelle vorübergehend auf einen gegenüber dem Nennstrom erhöhten Konstantstrom einstellbar ist, so daß sich eine nicht speisende Speisestelle durch unmittelbare manuelle oder selbsttätige Steuerung zur Übernahme der Speisung veranlassen läßt.

Vorzugsweise ist von vorneherein festgelegt, daß die erste Speisestelle bei Normalbetrieb die gesamte Strecke speist und die andere, als im Normalbetrieb nicht speisende, nur im Fehlerfall, d. h. Ausfall der ersten Speisestelle oder bei einem Streckenfehler die Fernspeisung übernimmt. In diesem Fall besitzt nur die zweite Speisestelle die genannte Ausgangscharakteristik.

Eine derartige Schaltungsanordnung wird zweckmäßigerweise so ausgebildet, daß die Speisestelle einen Referenzspannungserzeuger enthält, der wahlweise eine dem erhöhten Nennstrom zugeordnete erste Referenzspannung, eine dem Nennstrom zugeordnete zweite .Referenzspannung und eine dem reduzierten Nennstrom zugeordnete dritte Referenzspannung an einen Regelvergleicher abgibt und daß der Referenzspannungserzeuger derart voreinstellbar ist, daß er bei einer im Normalbetrieb speisenden Endstelle nur zwischen der ersten und zweiten Referenzspannung und bei einer im Normalbetrieb nicht speisenden Endstelle nur zwischen der zweiten und dritten Referenzspannung umsteuerbar ist.

Durch diese Maßnahmen ergibt sich der Vorteil, daß die erste und die zweite Speisestelle gleich aufgebaut sind und daß sich die Regelcharakteristik dabei wahlweise auf konstanten Nennstrom oder auf die vorgegebene Abhängigkeit von der Ausgangsspannung einstellen läßt.

Zweckmäßigerweise wird die zweite Referenzspannung mittels des durch die Ausgangsspannung steuerbaren, nach der vorgegebenen ersten Verzögerungszeit ansprechenden Schwellwertschalters herabgesetzt.

Die Dauer der vorübergehenden Erhöhung des Konstantstromes in der ersten Speisestelle wird insbesondere derart bemessen, daß sie größer als die erste Zeitkonstante ist.

Weiterhin kann man in wenigstens einer der Speisestellen eine Einrichtung zur Überwachung der Ausgangsspannung und/oder des Speisestromes vorsehen. Zweckmäßigerweise wird dabei bei der im Normalbetrieb nicht speisenden Speisestellen die Höhe der Gleichspannung oder die Polarität wenigstens einer der Ausgangsteilspannungen überwacht.

Weiterhin kann man bei der auf den größeren Stromwert eingestellten Konstantstromquelle Änderungen der Gleichspannung überwachen.

Die Erfindung wird anhand der in den Figuren dargestellen Ausführungsbeispiele näher erläutert.

Es zeigen

Figur 1 eine Schaltungsanordnung zur unterbrechungslosen Fernspeisung von Zwischenstellen einer Nachrichtenübertragungseinrichtung,

Figur 2 den Potentialverlauf bei der in Fig. 1 gezeigten Schaltungsanordnung bei ungestörtem Betrieb bzw. Ausfall einer Speisestelle,

Figur 3 die Ausgangscharakteristik von Speisestellen einer Schaltungsanordnung zur Fernspeisung,

Figur 4 eine Schaltungsanordnung zur unterbrechungslosen Fernspeisung von Zwischenstellen,

Figur 5 für die in Fig. 4 gezeigte Schaltungsanordnung den Potentialverlauf auf der Fernspeisestrecke bei ungestörtem Betrieb und

Figur 6 eine Speisestelle mit einem in unterschiedlicher Weise voreinstellbaren Regler.

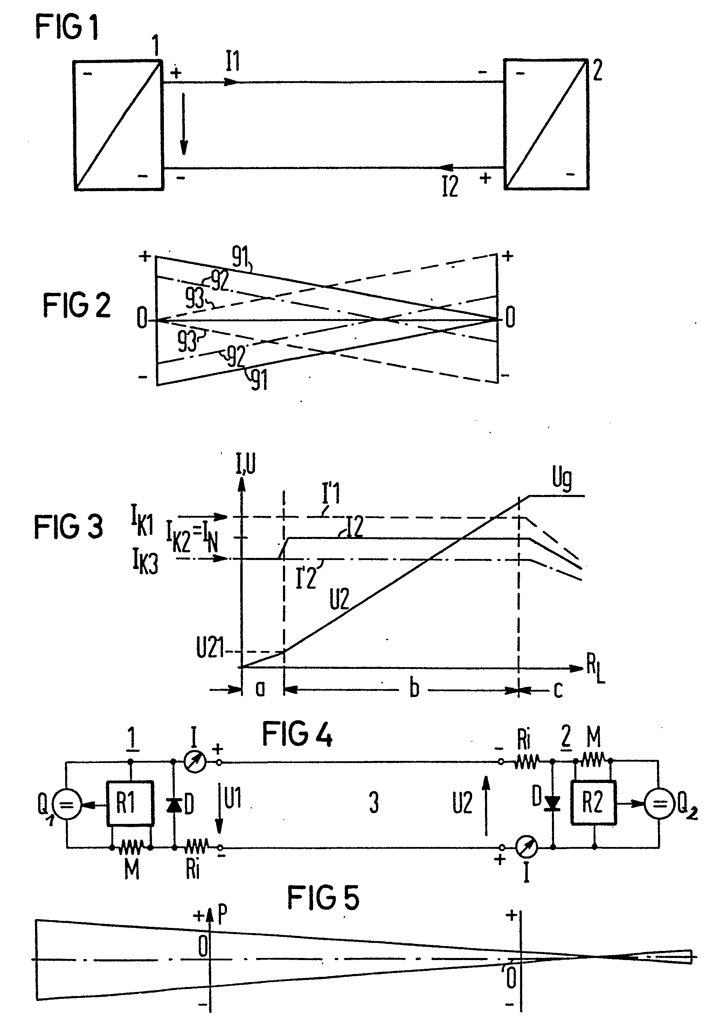

Figur 1 zeigt eine Anordnung zur unterbrechungsfreien Fernspeisung von Zwischenstellen einer Einrichtung zur Nachrichtenübertragung.

Dabei läuft der Fernspeisekreis über Speiseadern, die zusätzlich zu Lichtwellenleitern vorgesehen sein oder bei Koaxialleitungen, z. B. TF-Übertragungsstrecken durch die Innenleiter der Kabel gebildet sein können.

Die in der Figur nicht dargestellten Zwischenstellen werden mittels Reihenspeisung mit konstantem Gleichstrom gespeist.

Das Fernspeise-Adernpaar ist an beiden Enden jeweils an eine Fernspeisestelle bzw. ein Fernspeisegerät 1 bzw. 2 angeschlossen, so daß sich eine beidseitige Speisung mit gleichzeitig vorhandener Geräteredundanz ergibt. Dabei ist im Fernspeisekreis eine Reihenschaltung der beiden Fernspeisegeräte 1 und 2 wirksam. Jedes dieser beiden Fernspeisegeräte ist in der Lage, die ganze Fernspeisestrecke nach dem Prinzip der sog. « heißen Reserve » zu versorgen.

Figur 2 zeigt Beispiele für den Potentialverlauf auf der Fernspeisestrecke. Der Potentialnullpunkt liegt beim Geradenpaar 91 im Fernspeisegerät 2, beim Geradenpaar 93 im Fernspeisegerät 1. Im Falle 92 ist die Lastaufteilung zwischen den beiden Fernspeisegeräten 1 und 2 zufällig. Im Falle 91 liefert das Fernspeisegerät 1, im Falle 93 das Fernspeisegerät 2 die gesamte Leistung.

In Figur 3 ist die Ausgangscharakteristik eines Fernspeisegerätes dargestellt. In Abhängigkeit des Lastwiderstandes $R_L$ sind Strom und Spannung aufgetragen. Bei kleinen Lastwiderständen $R_L$, d. h. im Bereich a, der sich von Null bis zum unteren Grenzwert des Arbeitsbereichs b erstreckt, wird ein reduzierter Konstantstrom $I_{K3}$ abgegeben. Der Strom $I_{K3}$ ist einige, insbesondere etwa fünf Prozent kleiner als der Nennstrom In. Innerhalb des Arbeitsbereiches b speist das Fernspeisegerät mit konstantem Strom $I_{K2}$, der gleich dem Nennstrom In ist. Oberhalb des Arbeitsbereiches b wird die Spannung auf einen Wert $U_G$ begrenzt.

Zusätzlich ist in Fig. 3 auch ein erhöhter Konstantstrom eingetragen, der einige, insbesondere etwa fünf Prozent größer als der Nennstrom In ist. Dieser erhöhte Konstantstrom $I_{K1}$ wird, was in der Figur nicht näher dargestellt ist, von einem Fernspeisegerät vorübergehend abgegeben, das die Speisung der Strecke übernehmen soll.

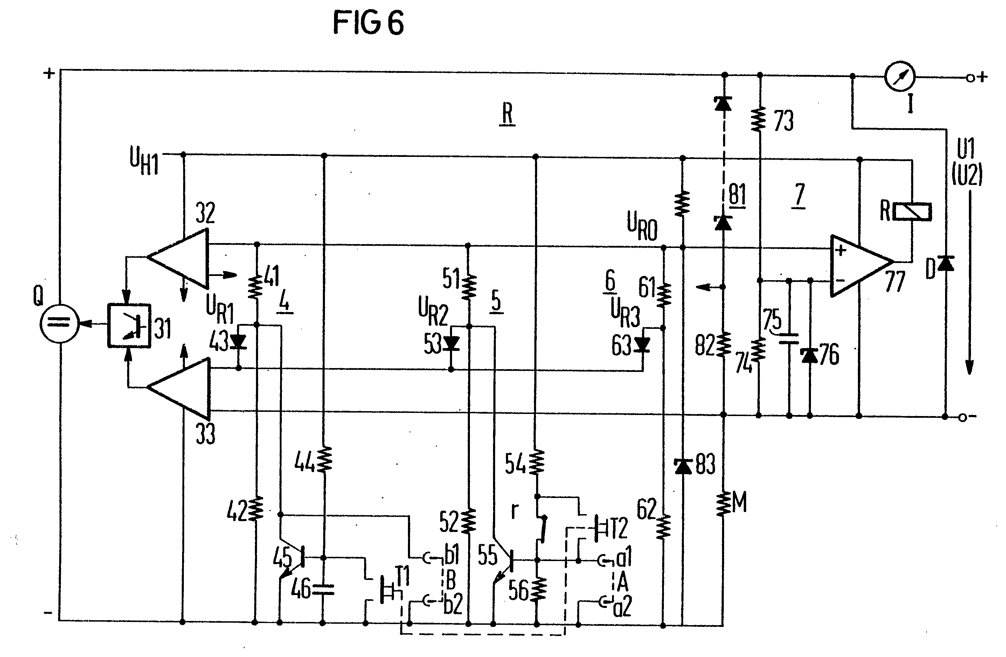

Figur 4 zeigt eine Schaltungsanordnung zur beidseitigen Fernspeisung mit einem definierten Potentialverlauf, der aus Fig. 5, Fall 91 hervorgeht. Das Fernspeisegerät 1 ist in diesem Fall als aktives Gerät mit Hilfe des Reglers R1 auf Nennstrom In eingestellt. Das zweite Fernspeisegerät 2 besitzt als passives Gerät einen Regler R2 mit der in Fig. 3 gezeigten Ausgangs- bzw. Regelcharakteristik.

Beide Fernspeisegeräte enthalten jeweils eine Stromquelle Q, die durch einen Regler R1 bzw. R2 gesteuert wird. Dem Regler sind jeweils sowohl die an einem Meßwiderstand M abfallende Spannung als auch die Ausgangsspannung des Fernspeisegerätes 1 bzw. 2 zugeführt. Beide Regler R1 und R2 sind, was in Fig. 4 nicht dargestellt ist, in gleicher Weise ausgebildet und mittels Brücken auf die eine oder andere Regelcharakteristik eingestellt. Außerdem besitzen sie jeweils eine Taste, die beim Regler R1 eine Erhöhung des Ausgangsstromes und beim Regler R2 eine Herabsetzung des Ausgangsstromes bewirkt.

Parallel zum Ausgang des Fernspeisegerätes 1 bzw. 2 ist jeweils eine derart gepolte Diode D vorgesehen, daß die Fernspeiseschleife für einen vom anderen Fernspeisegerät kommenden Speisestrom geschlossen ist. Zwischen dieser Diode D und dem Ausgang des Fernspeisegerätes 1 bzw. 2 ist jeweils ein Innenwiderstand $R_i$ wirksam,

der insbesondere so bemessen ist, daß die an ihm abfallende Spannung für Überwachungszwecke geeignet ist. Außerdem ist zwischen dem Ausgang der Speisestelle und der Diode D jeweils ein Strommesser I vorgesehen.

Im Normalbetrieb bzw. während des ungestörten Streckenbetriebes speist das Fernspeisegerät 1 die gesamte Strecke, während das Fernspeisegerät 2 keinen Strom liefert. Fällt das Fernspeisegerät 1 aus, so übernimmt das Fernspeisegerät 2 die Speisung der Strecke. Bei einer Verbindung zwischen den Strompfaden an einer beliebigen Stelle der Strecke übernimmt das Fernspeisegerät 2 die Speisung bis dorthin mit vollem Strom. Dabei ist es zweckmäßig, diesen Zustand durch einen Streckenfehler-Alarm anzuzeigen. Sobald nun das Gerät 1 wieder betriebsfähig ist bzw. nach Wiederherstellung des normalen Streckenzustandes, stellt sich auf der Strecke zunächst ein beliebiger Potentialverlauf entsprechend Fig. 2, Geradenpaar 92 ein, da im Arbeitsbereich a beide Geräte gleichwertig sind bzw. nun in beiden Geräten auf Nennstrom geregelt wird. Zur Wiederherstellung des gewünschten Speisebetriebes, bei dem nur das Gerät 1 speist, ist somit Gerät 2 wieder in den passiven Zustand zurückzuversetzen. Dies kann insbesondere dadurch geschehen, daß sich am Gerät 2 entsprechend der in Fig. 3 gezeigten strichpunktierten Linie die Stromregelung im gesamten Lastbereich geringfügig um mehrere, insbesondere etwa fünf Prozent vorübergehend, d. h. bis zur Lastübernahme durch das Gerät 1, herabsetzen läßt.

Eine andere Möglichkeit besteht darin, daß sich am Gerät 1 die Stromregelung im gesamten Lastbereich entsprechend der in Fig. 3 gezeigten strichlierten Linie um mehrere, insbesondere um etwa fünf Prozent vorübergehend heraufsetzen läßt.

Figur 6 zeigt weitere Einzelheiten eines Reglers R, der mit Hilfe wahlweise einsetzbarer Brücken als Regler R1 oder als Regler R2 Verwendung finden kann. Diese Brücken können auch in der Geräteaufnahme vorhanden sein, so daß schon durch Einschieben des Gerätes die Arbeitsweise definiert ist und kein Eingriff innerhalb des Gerätes erforderlich wird.

Die vorübergehende Herabsetzung des Speisestromes kann auch in einem Kurzschließen des Ausganges des betreffenden Fernspeisegerätes über eine Tast bestehen. Durch die vorübergehende Reduzierung des Speisestromes wird erreicht, daß sich die interne Stromregelung wieder auf den reduzierten Stromwert einstellt und wegen der sofortigen Lastübernahme durch das gegenüberliegende Gerät auch stabil erhalten bleibt. Gleichzeitig wird auch der mit dem Arbeitszustand des bei Normalbetrieb passiven Gerätes gekoppelte Streckenfehleralarm dadurch wieder gelöscht. Mit einer derartigen Tast, die vorzugsweise nur an dem für den passiven Betrieb vorgesehenen Gerät wirksam sein soll, läßt sich auch während des normalen Streckenbetriebes der Strom des passiven Gerätes überprüfen, da ein im Ausgangskreis liegendes Meßinstrument bei diesem Betriebszustand zwar den Streckenstrom, aber nicht den geräteeigenen Strom anzeigt.

Die in Fig. 6 gezeigte Speisestelle ist so ausgebildet, daß sie wahlweise als im Normalbetrieb nicht speisende Speisestelle 2 Verwendung finden kann. Der in der Speisestelle enthaltene Regler R läßt sich mittels Einlegen der Brücke A zwischen den Anschlüssen a1 und a2 als im Normalbetrieb speisende Speisestelle voreinstellen. Zur Voreinstellung als im Normalbetrieb nicht speisende Speisestelle entfällt die Brücke A und die Brücke B wird zwischen den Anschlüssen b1 und b2 eingelegt.

Die Speisestelle enthält die Gleichstromquelle Q, die über das Stellglied 31 durch die beiden Regelvergleicher 32 und 33 steuerbar ist. Parallel zum Ausgang der Speisestelle liegt die Diode D, die für den von der Speisestelle selbst gelieferten Strom in Sperrichtung gepolt ist. Zwischen der Minusklemme des Ausgangs und der Stromquelle Q liegt der Meßwiderstand M. Die Plusklemme ist über den Strommesser I an die Stromquelle Q geführt.

Der Regelvergleicher 33 dient zur Konstant stromregelung. Der weitere Regelvergleicher 32 vergleicht den Spannungsabfall, der an einem in Reihe zur Z-Dioden-Kette 81 liegenden Widerstand 82 bei wirkender Spannungsbegrenzung durch die Z-Diodenkette anliegt mit der Haupt-Referenzspannung $U_{R0}$ und begrenzt durch Verringerung des von der Quelle Q abgegebenen Gleichstromes den durch die Zenerkette fließenden Anteil.

Die Speisestelle enthält einen Referenzspannungserzeuger, der wahlweise eine dem erhöhten Nennstrom $I_{K1}$ zugeordnete erste Referenzspannung $U_{R1}$, eine dem Nennstrom $I_N$ zugeordnete zweite Referenzspannung $U_{R2}$ und eine dem reduzierten Nennstrom $I_{K3}$ zugeordnete dritte Referenzspannung $U_{R3}$ an den Regelvergleicher 33 abgibt. Der Referenzspannungserzeuger läßt sich mittels der wahlweise einsetzbaren Brücken derart voreinstellen, daß er bei einer im Normalbetrieb speisenden Endstelle 1 nur zwischen der ersten und zweiten Referenzspannung $U_{R1}$ bzw. $U_{R2}$ und bei einer im Normalbetrieb nicht speisenden Endstelle 2 nur zwischen der zweiten und dritten Referenzspannung $U_{R2}$ bzw. $U_{R3}$ gesteuert wird.

Die in den Referenzspannungsgebern 4, 5 und 6 erzeugten Referenzspannungen $U_{R1}$, $U_{R2}$ und $R_{R3}$ sind über die Entkopplungsdioden 43, 53, 63 an den Regelvergleicher 33 geführt. Ferner lassen sich die Referenzspannungen $U_{R1}$ bzw. $U_{R2}$ jeweils mittels einer steuerbaren Vorrichtung zur wahlweisen Herabsetzung der Referenzspannung unter den Wert der dritten Referenzspannung drücken. Mittels der in einer im Normalbetrieb speisenden Endstelle vorgesehenen Brücke A wird die Vorrichtung zur Herabsetzung der zweiten Referenzspannung $U_{R2}$ blockiert. Mittels der in einer im Normalbetrieb nicht speisenden Endstelle vorgesehenen Brücke B wird die Herabsetzung der ersten Referenzspannung $U_{R1}$ fest eingestellt.

Zur Erzeugung der Referenzspannung dient ein Referenzspannungserzeuger, der die drei Referenzspannungsgeber 4, 5 und 6 enthält. Jeder Referenzspannungsgeber 4, 5 bzw. 6 enthält einen an die Haupt-Referenzspannung $U_{R0}$ angeschlossenen ohmschen Spannungsteiler 41, 42; 51, 52 bzw. 61, 62. Die Abgriffe dieser Spannungsteiler sind über je eine Diode 43, 53 bzw. 63 an den Regelvergleicher 33 geführt, so daß jeweils die größte der drei Referenzspannungen als Bezugsgröße wirksam ist. Die Haupt-Referenzspannung $U_{R0}$ wird von der Z-Diode 83 abgegeben.

Die Vorrichtung zur wahlweisen Herabsetzung der ersten Referenzspannung $U_{RA}$ enthält den Transistor 45, dessen Emitter-Kollektor-Strecke den Widerstand 42 überbrückt. Die Vorrichtung zur wahlweisen Herabsetzung der zweiten Referenzspannung enthält den Transistor 55, dessen Emitter-Kollektor-Strecke parallel zum Widerstand 52 liegt.

Beim Transistor 45 ist die Basis sowohl über den Kondensator 46 als auch über die Taste T1 an den Emitter und über den Widerstand 44 an die Hilfsspannung $U_{H1}$ geführt.

Der Transistor 55 ist mit seiner Basis über den Widerstand 56 an den Emitter und über den Ruhekontakt r des Relais R und den dazu in Serie liegenden Widerstand 54 an die Hilfsspannung $U_{H1}$ geführt. Parallel zum Ruhekontakt r liegt die Taste T2, die gleichzeitig mit der Taste T1 betätigbar ist.

Die Basis-Emitter-Strecke des Transistors 55 läßt sich durch die Brücke A überbrücken. Parallel zur Kollektor-Emitter-Strecke des Transistors 45 läßt sich die Brücke B legen.

Das Relais R wird von dem als Spannungsvergleicher dienenden Operationsverstärker 77 gespeist. Parallel zum Ausgang der Speisestelle liegt der aus den Widerständen 73 und 74 bestehende Spannungsteiler, dessen Abgriff an den invertierenden Eingang des Operationsverstärkers 77 geführt ist. Der nicht invertierende Eingang des Operationsverstärkers 77 liegt an der Haupt-Referenzspannung $U_{R0}$. Parallel zum Widerstand 74 liegen sowohl die Z-Diode 76 als auch der Kondensator 75. Die Zeitkonstante dieser Anordnung beträgt insbesondere etwa eine Sekunde.

Für eine Verwendung als Speisestelle 1 (Fig. 3), die im Normalbetrieb Nennstrom liefert, wird die Brücke A eingelegt. Der Transistor 55 ist in diesem Fall gesperrt, unabhängig davon, ob das Relais R angezogen hat oder die Taste T2 betätigt wird. Die zweite Referenzspannung $U_{R2}$ ist daher im zweiten Referenzspannungsgeber immer vorhanden. Da die Brücke B in diesem Fall fehlt, setzt der bei unbetätigter Taste T1 leitende Transistor 45 die erste Referenzspannung $U_{R1}$ soweit herab, daß als größte der drei Referenzspannungen $U_{R1}$, $U_{R2}$, $R_{R3}$ am Regelvergleicher 33 nur die dem Nennstrom zugeordnete Referenzspannung $U_{R2}$ wirksam ist.

Wird die Taste T1 betätigt, so wird der Transistor 45 gesperrt und die Herabsetzung der Referenzspannung $U_{R1}$ im ersten Referenzspannungsgeber aufgehoben. Der gleiche Zustand stellt sich bei Inbetriebnahme des Gerätes ein, wenn der Kondensator 46 entladen ist. In diesem Fall wird nur während einer durch den Kondensator 46 und den Widerstand 44 vorgegebenen Zeitdauer $\tau 2$ (Fig. 4), die vorzugsweise etwa 2 Sekunden beträgt, die Referenzspannung $U_{R1}$ wirksam.

Bei Voreinstellung auf eine Speisestelle 2 (Fig. 3), die im Normalbetrieb nicht speist, wird die Brücke B eingelegt. Der Widerstand 42 ist somit ständig kurzgeschlossen, so daß die Referenzspannung $U_{R1}$ fehlt. Es kann somit lediglich die Referenzspannung $U_{R2}$ oder $U_{R3}$ wirksam werden. Im Normalbetrieb, d. h. bei Ausgangsspannungen, die kleiner als der Wert U21 sind, ist das Relais R abgefallen, der Ruhekontakt r geschlossen und der Transistor 55 leitend. Die zweite Referenzspannung $U_{R2}$ ist dadurch soweit herabgesetzt, daß die dritte Referenzspannung $U_{R3}$ am Regelvergleicher 33 wirksam ist. Die Speisestelle ist auf den reduzierten Konstantstrom $J_{K3}$ eingestellt.

Bei Ausgangsspannungen, die größer als der Wert U21 sind, spricht das Relais R an und der Ruhekontakt r ist geöffnet. Der Transistor 55 ist daher gesperrt, so daß die dem Nennstrom $J_N$ zugeordnet zweite Referenzspannung $U_{R2}$ wirksam ist. Die Speisestelle speist mit Nennstrom $J_N$. Die durch den geöffneten Ruhekontakt r bewirkte Blockierung der Vorrichtung zur Herabsetzung der zweiten Referenzspannung $U_{R2}$ kann durch Betätigung der Taste T2 vorübergehend aufgehoben werden, d. h. die Speisestelle vorübergehend auf reduzierten Konstantstrom $J_{K3}$ eingestellt werden.

Sinkt die Ausgangspannung unter den Wert U1, so fällt das Relais R ab, der Ruhekontakt r schließt, der Transistor 55 wird leitend gesteuert und setzt die zweite Referenzspannung $U_{R2}$ so weit herab, daß sie nicht mehr wirksam ist. Die Speisestelle ist auf reduzierten Konstantstrom $J_{K3}$ eingestellt.

Die vorübergehende Erhöhung oder Reduzierung des Speisestromes kann von Hand durch die Tasten $T_1$, $T_2$ bewirkt werden. Sie kann aber, was in den Figuren nicht näher dargestellt ist, darüber hinaus auch selbsttätig ablaufen. Insbesondere liefert die Speisestelle 1 unmittelbar nach seiner Inbetriebnahme kurzzeitig, vorzugsweise etwa zwei Sekunden lang, den erwähnten geringfügig erhöhten Fernspeisestrom $J_{K1}$.

Ferner kann ggf. in der Speisestelle 2 bei Lastübernahme nach einer bestimmten Zeit, insbesondere nach einigen Sekunden, die erwähnte kurzzeitige geringfügige Stromabsenkung selbsttätig einmal ausgelöst werden.

Die genannten automatischen Stromänderungen haben den Vorteil, daß sich nach einem vorübergehenden Streckenfehler, z. B. Blitzschlag, nach einem Ausfall der Batteriespannung oder nach einem Austausch der Fernspeisegeräte der erwünschte einseitige Betrieb automatisch wiederherstellt. Dies ist insbesondere für einen Einsatz der Geräte in unbemannten Speisestellen von Vorteil.

Bei länger dauernden Streckenfehlern, insbesondere bei Kurzschluß oder Unterbrechung mit Schleifenschluß über einen sog. Schaltzusatz läßt sich nach Beendigung der Reparaturarbeiten der ursprüngliche Speisezustand durch Betätigen der Taste in einer der beiden Speisestellen 1 oder 2 von Hand wiederherstellen.

Die zur Signalisierung von Streckenfehlern dienende Spannungsüberwachung am Ausgang der zweiten Speisestelle kann ggf. darin bestehen, daß die Polung der Ausgangs-Teilspannungen überwacht wird. Außerdem kann die zweite Speisestelle zweckmäßigerweise einen Stromdiskriminator enthalten, der bei speisender zweiter Speisestelle eine Fehlermeldung auslöst.

## Ansprüche

1. Schaltungsanordnung zur Fernspeisung von Zwischenstellen einer Einrichtung der Nachrichtenübertragungstechnik mittels Gleichstrom-Reihenspeisung, wobei in einem Fernspeisekreis eine Reihenschaltung von zwei in Speisestellen (1, 2) der Nachrichtenübertragungseinrichtung vorgesehenen, über ein Speiseadernpaar miteinander verbundenen Stromquellen (Q) vorgesehen ist und wobei eine in einer ersten Speisestelle (1) enthaltene erste Stromquelle ($Q_1$) einen konstanten Nennstrom und eine in einer zweiten Speisestelle (2) enthaltene zweite Stromquelle ($Q_2$) einen gegenüber dem Nennstrom reduzierten Konstantstrom abgeben kann, derart, daß im Normalbetrieb nur die den Nennstrom abgebende erste Speisestelle (1) speist, dadurch gekennzeichnet, daß wenigstens die zweite Stromquelle (R2, $Q_2$) eine derart von der Ausgangsspannung (U2) abhängige Regelcharakteristik hat, daß in einem vorgegebenen Bereich (b) der Ausgangsspannung (U2) der Nennstrom ($I_N$) und unterhalb dieses Spannungsbereiches (b) der reduzierte Konstantstrom ($I_{K3}$) abgegeben werden (Fig. 2, 3).

2. Schaltungsanordnung nach Anspruch 1, dadurch gekennzeichnet, daß der untere Grenzwert (U21) des vorgegebenen Bereiches (b) der Ausgangsspannung (U2) derart bemessen ist, daß er etwas kleiner ist als die zur Speisung eines Verstärkerfeldes mit dem reduzierten Konstantstrom erforderliche Ausgangsspannung (U2).

3. Schaltungsanordnung nach Anspruch 1 oder 2, dadurch gekennzeichnet, daß wenigstens die zweite Speisestelle (2) einen an deren Ausgangsspannung (U2) angeschlossenen Schwellwertschalter (77) enthält, der bei Ausgangsspannungen oberhalb des unteren Grenzwertes (U1) des vorgegebenen Bereiches (b) der Ausgangsspannung einen der Stromquelle (Q) zugeordneten Konstantstromregler (33) auf den Nennstrom ($J_N$) einstellt und daß der Schwellwertschalter (77) auf Änderungen der Ausgangsspannung mit einer vorgegebenen ersten Verzögerung (τ1) anspricht.

4. Schaltungsanordnung nach einem der Ansprüche 1 bis 3, dadurch gekennzeichnet, daß wenigstens die zweite Speisestelle (2) unabhängig von ihrer Ausgangsspannung (U2) vorübergehend auf einen reduzierten Konstantstrom ($I_{K3}$) einstellbar ist.

5. Schaltungsanordnung nach einem der Ansprüche 1 bis 4, dadurch gekennzeichnet, daß wenigstens die erste Speisestelle (1) vorübergehend auf einen gegenüber dem Nennstrom ($I_N$) erhöhten Konstantstrom ($I_{K1}$) einstellbar ist.

6. Schaltungsanordnung nach einem der Ansprüche 1 bis 5, dadurch gekennzeichnet, daß die Speisestelle (1, 2) einen Referenzspannungserzeuger enthält, der wahlweise eine dem erhöhten Nennstrom ($I_{K1}$) zugeordnete erste Referenzspannung ($U_{R1}$), eine dem Nennstrom ($I_N$) zugeordnete zweite Referenzspannung ($U_{R2}$) und eine dem reduzierten Nennstrom ($I_{K3}$) zugeordnete dritte Referenzspannung ($U_{R3}$) an einen Regelvergleicher (33) abgibt und daß der Referenzspannungserzeuger derart voreinstellbar ist, daß er bei einer im Normalbetrieb speisenden Endstelle (1) nur zwischen der ersten und zweiten Referenzspannung ($U_{R1}$, $U_{R2}$) und bei einer im Normalbetrieb nicht speisenden Endstelle (2) nur zwischen der zweiten und dritten Referenzspannung ($U_{R2}$, $U_{R3}$) umsteuerbar ist (Fig. 4).

7. Schaltungsanordnung nach Anspruch 6, dadurch gekennzeichnet, daß der Referenzspannungserzeuger über Entkopplungsdioden (43, 53, 63) an den Regelvergleicher (33) geführte Referenzspannungsgeber (4, 5, 6) enthält und daß die für die erste und für die zweite Referenzspannung ($U_{R1}$, $U_{R2}$) vorgesehenen Referenzspannungsgeber (4, 5) jeweils mit einer steuerbaren Vorrichtung zur wahlweisen Herabsetzung der Referenzspannung ($U_{R1}$, $U_{R2}$) unter den Wert der dritten Referenzspannung ($U_{R3}$) vorgesehen sind und daß durch die Voreinstellung bei einer im Normalbetrieb speisenden Speisestelle (1) die Vorrichtung zur Herabsetzung der zweiten Referenzspannung ($U_{R2}$) blockiert und bei einer im Normalbetrieb nicht speisenden Speisestelle (2) die Herabsetzung der ersten Referenzspannung ($U_{R1}$) fest eingestellt ist.

8. Schaltungsanordnung nach Anspruch 1, 6 oder 7, dadurch gekennzeichnet, daß die zweite Referenzspannung ($U_{R2}$) mittels des durch die Ausgangsspannung (U2) steuerbaren, nach einer vorgegebenen ersten Verzögerungszeit (τ1) ansprechenden, Schwellwertschalters (77) herabsetzbar ist.

9. Schaltungsanordnung nach Anspruch 5 und 8, dadurch gekennzeichnet, daß die Dauer (τ2) der vorübergehenden Erhöhung des Konstantstromes in der ersten Speisestelle (1) derart bemessen ist, daß sie größer als die erste Zeitkonstante (τ1) ist.

10. Schaltungsanordnung nach einem der vorhergehenden Ansprüche, dadurch gekennzeichnet, daß in wenigstens einer der Speisestellen (1, 2) eine Einrichtung zur Überwachung der Ausgangsspannung (U) vorgesehen ist.

## Claims

1. A circuit arrangement for remote feeding intermediate stations of a device relating to communications transmission technology by means of direct current series-feeding, where there is arranged in a remote feeding circuit a series connection of two current sources (Q) in the supply stations (1, 2) of the communications transmission device and connected to one another by means of a pair of power supply leads, and a first current source ($Q_1$) contained in a first supply station (1) can emit a constant nominal current and a second current source ($Q_2$) contained in a second supply station (2) can emit a constant current that is reduced relative to the nominal current, in such manner that during normal operation only the first supply station (1) emits the nominal current, characterised in that at least the second current source (R2, $Q_2$) has a regulating characteristic which depends upon the output voltage (U2) in such manner that the nominal current ($I_N$) is emitted when the output voltage (U2) is in a given region (b) and the reduced constant current ($I_{K3}$) is emitted below this voltage region (b). (Fig. 2, 3).

2. A circuit arrangement as claimed in Claim 1, characterised in that the lower limit value (U21) of the given region (b) of the output voltage (U2) is smaller than the output voltage (U2) which is required for feeding an amplifier field with the reduced constant current.

3. A circuit arrangement as claimed in Claim 1 or 2, characterised in that at least the second supply station (2) comprises a threshold value switch (77) which is connected to the output voltage (U2) of said supply station and which sets a constant current regulator (33) assigned to the current source (Q) to a nominal current ($J_N$), in the case of output voltages above the lower limit value (U1) of the given region (b) of the output voltage, and that the threshold value switch (77) responds to changes of the output voltage with a predetermined first delay (τ1).

4. A circuit arrangement as claimed in one of Claims 1 to 3, characterised in that at least the second supply station (2) can be temporarily adjusted to a reduced constant current ($I_{K3}$) independently of its output voltage (U2).

5. A circuit arrangement as claimed in one of Claims 1 to 4, characterised in that at least the first supply station (1) can be temporarily set to a constant current ($I_{K1}$) which is increased relative to the nominal current ($I_N$).

6. A circuit arrangement as claimed in one of the Claims 1 to 5, characterised in that the supply station (1, 2) comprises a reference voltage generator which can optionally emit a first reference voltage ($U_{R1}$) assigned to the increased nominal current ($I_{K1}$), a second reference voltage ($U_{R2}$) assigned to the nominal current ($I_N$) and a

third reference ($U_{R3}$) assigned to the reduced nominal current ($I_{K3}$) to a regulating comparator (33), and that the reference voltage generator is preadjustable in such manner that it can only be reversed between the first and the second reference voltage ($U_{R1}$, $U_{R2}$) in a terminal station (1) which supplies power during normal operation, and only between the second and third reference voltage ($U_{R2}$, $U_{R3}$) in a terminal station which does not supply power during normal operation (Fig. 4).

7. A circuit arrangement as claimed in Claim 6, characterised in that the reference voltage generator comprises reference voltage supplies (4, 5, 6) which are directed to the regulating comparator (33) by means of decoupling diodes (43, 53, 63), and that the reference voltage supplies ($U_{R1}$, $U_{R2}$) which are provided for the first and for the second reference voltage ($U_{R1}$, $U_{R2}$) are respectively equipped with a controllable device for the optional reduction of the reference voltage ($U_{R1}$, $U_{R2}$) below the value of the third reference voltage ($U_{R3}$), and that by means of the presetting in a supply station (1) feeding power during normal operation, the device for reducing the second reference voltage ($U_{R2}$) is blocked and in a supply station (2) which does not feed power during normal operation the reduction of the first reference voltage ($U_{R1}$) is firmly set.

8. A circuit arrangement as claimed in Claim 1, 6 or 7, characterised in that the second reference voltage ($U_{R2}$) can be reduced by means of the threshold value switch (77) which is controllable by the output voltage (U2) and responds after a predetermined first delay time ($\tau$1).

9. A circuit arrangement as claimed in Claim 5 and 8, characterised in that the duration ($\tau$2) of the temporary increase of the constant current in the first supply station (1) is greater than the first time constant ($\tau$1).

10. A circuit arrangement as claimed in one of the preceding claims, characterised in that in at least one of the supply stations (1, 2), there is arranged a device for monitoring the output voltage (U).

## Revendications

1. Circuit pour l'alimentation à distance de stations intermédiaires d'une installation de télécommunication, au moyen d'une alimentation série en courant continu, un montage série de deux sources de courant (Q), reliées entre elles par l'intermédiaire d'une paire de conducteurs d'alimentation et prévues dans des postes d'alimentation (1, 2) de l'installation de télécommunication, étant prévu dans un circuit d'alimentation à distance, et une première source de courant (Q1) contenue dans un premier poste d'alimentation (1) pouvant délivrer un courant nominal constant, et une seconde source de courant (Q2) contenue dans un second poste d'alimentation (2) pouvant délivrer un courant constant réduit par rapport au courant nominal de manière qu'en fonctionnement normal seul le premier poste d'alimentation (1) délivrant le courant nominal assure l'alimentation, caractérisé par le fait qu'au moins la seconde source de courant (R2, Q₂) possède une caractéristique de régulation qui dépend de la tension de sortie (U2) de manière que le courant nominal ($I_N$) soit délivré dans une gamme prédéterminée (b) de la tension de sortie (U2), et que le courant constant réduit ($I_{K3}$) soit délivré en dessous de cette gamme de tension (b) (fig. 2, 3).

2. Circuit suivant la revendication 1, caractérisé par le fait que la valeur limite inférieure (U21) de la gamme prédéterminée (b) de la tension de sortie (U2) est dimensionnée de manière à être légèrement plus faible que la tension de sortie (U2) nécessaire pour l'alimentation d'un champ amplificateur avec le courant constant réduit.

3. Circuit suivant la revendication 1 ou 2, caractérisé par le fait qu'au moins le second poste d'alimentation (2) comporte un commutateur à valeur de seuil (77), relié à sa tension de sortie (U2), qui, dans le cas de tensions de sortie supérieures à la valeur limite inférieure (U1) de la gamme prédéterminée (b) de la tension de sortie, règle un régulateur de courant constant (33), associé à la source de courant (Q), sur le courant nominal ($I_N$), et que le commutateur à valeur de seuil (77) répond à des variations de la tension de sortie avec un premier retard prédéterminé ($\tau$1).

4. Circuit suivant l'une des revendications 1 à 3, caractérisé par le fait qu'au moins le second poste d'alimentation (2) peut être réglé temporairement sur un courant constant réduit ($I_{K3}$), indépendamment de sa tension de sortie (U2).

5. Circuit suivant l'une des revendications 1 à 4, caractérisé par le fait qu'au moins le premier poste d'alimentation (1) peut être réglé temporairement sur un courant constant ($I_{K1}$) augmenté par rapport au courant nominal ($I_N$).

6. Circuit suivant l'une des revendications 1 à 5, caractérisé par le fait que le poste d'alimentation (1, 2) comporte un générateur de tension de référence qui délivre au choix une première tension de référence ($U_{R1}$) associée au courant nominal augmenté ($I_{K1}$), une seconde tension de référence ($U_{R2}$) associée au courant nominal ($I_N$), et une troisième tension de référence ($U_{R3}$) associée au courant nominal réduit ($I_{K3}$), à un comparateur de régulation (33), et que le générateur de tension de référence peut être préréglé de manière à ne pouvoir être commuté qu'entre les première et seconde tensions de référence ($U_{R1}$, $U_{R2}$) dans le cas d'un poste terminal (1) assurant l'alimentation en fonctionnement normal, et qu'entre les seconde et troisième tensions de référence ($U_{R2}$, $U_{R3}$) dans le cas d'un poste terminal (2) n'assurant pas l'alimentation en fonctionnement normal (fig. 4).

7. Circuit suivant la revendication 6, caractérisé par le fait que le générateur de tension de référence comporte un circuit de formation de tension de référence (4, 5, 6) relié au comparateur de régulation (3) par l'intermédiaire de diodes de découplage, et que les circuits de formation de tension de référence (4, 5) prévus pour les première et seconde tensions de référence ($U_{R1}$, $U_{R2}$) sont respectivement munis d'un dispositif commandable pour réduire sélectivement la tension de référence ($U_{R1}$, $U_{R2}$) jusqu'à une valeur inférieure à la troisième tension de référence ($U_{R3}$), et que grâce au préréglage, le dispositif pour réduire la seconde tension de référence ($U_{R2}$) est bloqué dans le cas d'un poste d'alimentation en fonctionnement normal, et la réduction de la première tension de référence ($U_{R1}$) est réglée de façon fixe dans le cas d'un poste d'alimentation (2) n'assurant pas l'alimentation en fonctionnement normal.

8. Circuit suivant la revendication 1, 6 ou 7, caractérisé par le fait que la seconde tension de référence ($U_{R2}$) peut être réduite au moyen du commutateur à valeur de seuil (77) qui répond après un premier retard prédéterminé ($\tau 1$) et qui peut être commandé par la tension de sortie (U2).

9. Circuit suivant la revendication 5 et 8, caractérisé par le fait que la durée ($\tau 2$) de l'augmentation temporaire du courant constant dans le premier poste d'alimentation (1) est dimensionnée de manière à être plus importante que la première constante de temps ($\tau 1$).

10. Circuit suivant l'une des revendications précédentes, caractérisé par le fait qu'un dispositif pour surveiller la tension de sortie (U) est prévu dans au moins un des postes d'alimentation (1, 2).

**FIG 1**

**FIG 2**

**FIG 3**

**FIG 4**

**FIG 5**

FIG 6

0 030 004